# EUROPEAN PATENT APPLICATION

(11) **EP 2 056 069 A1**
(43) Date of publication of application: **06.05.2009**
(21) Application number: 07807499.4
(22) Date of filing: 19.09.2007
(51) Int. Cl.: G01C 19/56, G01P 9/04, H01L 41/08

(54) **ANGULAR VELOCITY SENSOR**

(30) Priority: 21.09.2006 JP 2006255590; 21.09.2006 JP 2006255591
(71) Applicant: Panasonic Corporation, Kadoma-shi Osaka 571-8501 (JP)
(72) Inventor: TERADA, Jirou c/o Panasonic Corp. IPROC, IP Dev. Center, Chuo-ku, Osaka-shi, Osaka 540-6207 (JP)
(74) Representative: Pautex Schneider, Nicole Véronique
(86) International application number: PCT/JP2007/068111
(87) International publication number: WO 2008/035683

(57) **Abstract**

An angular velocity sensor detects an angular velocity of an object. The angular velocity sensor includes a detecting element, and a driving unit. The detecting element includes a supporting part, a first arm extending from the supporting part and being adapted to be fixed to the object, a second arm extending from the supporting part, and a first weight connected with the second arm. The second arm has substantially a U-shape and includes a first extending part extending from the supporting part, a first facing part facing the first extending part and extending in parallel with the first extending part, and a first joint part joining the first extending part to the first facing part. The first weight is connected with the facing part of the second arm. The driving unit includes first to fourth drivers. The first driver is provided at the first extending part and extends and contracts the first extending part. The second driver is positioned at the first extending part at a more outer circumference of the U-shape of the second arm than the first driver. The second driver extends and contracts the first extending part. The third driver is positioned at the first facing part, and extends and contracts the first facing part. The fourth driver is positioned at the first facing part at a more inner circumference of the U-shape of the second arm than the third driver, and extends and contracts the first facing part. This angular velocity sensor has a small size along a rotation axis about which an angular velocity to be detected.

## Description

### TECHNICAL FIELD

The present invention relates to an angular velocity sensor which detects an angular velocity and is used for various electronic devices for attitude control and navigation for a movable object, such as an aircraft, automobile, robot, shipping craft, and vehicle.

### BACKGROUND ART

An angular velocity sensor electrically detects a strain due to a Coriolis force produced by a rotation to determine an angular velocity of the rotation.

Fig. 5 is a perspective view of conventional angular velocity sensor 5001 disclosed in Patent Document 1. Fig. 6 is a sectional view of angular velocity sensor 5001 at line 6-6 shown in Fig. 5. Angular velocity sensor 5001 includes a detecting element having a tuning fork shape having two arms 52 and base 53 joined to two arms 52.

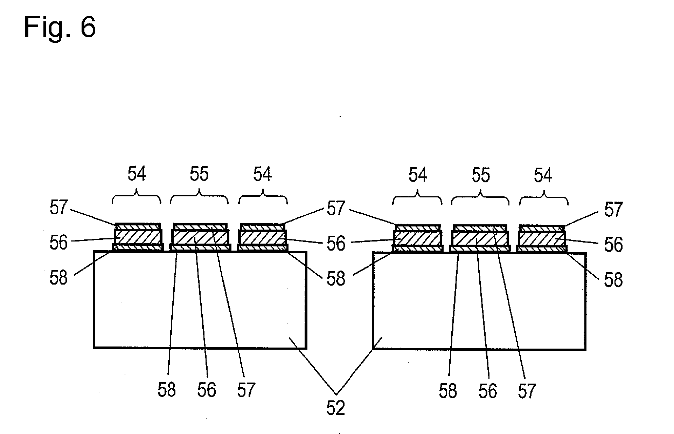

Driver 54 vibrating arm 52 and sensor 55 sensing a strain of arm 52 resulting from an angular velocity are provided on arms 52. As shown in Fig. 6, each of driver 54 and sensor 55 includes lower electrode 58 provided on arm 52, piezoelectric body 56 provided on lower electrode 58, and upper electrode 57 provided on piezoelectric body 56. Signal line 59 is drawn out from each of electrodes 57 and 58 of driver 54 and sensor 55, extends to base 53, and is connected with electrode pad 60 provided on base 53. Electrode pad 60 is electrically connected via a bonding wire to a wiring pattern of a circuit board having angular velocity sensor 5001 mounted thereon.

An operation of angular velocity sensor 5001 will be described in an XYZ-coordinate space defined by an X-axis, a Y-axis, and a Z-axis which are perpendicular to each other. Angular velocity sensor 5001 is arranged so that arms 52 extend along the Z-axis and are arranged along the X-axis. While an alternating current (AC) voltage is applied to driver 54 so as to vibrate arm 52 in direction 5001A along the X-axis, rotating angular velocity sensor 501 rotates together with the X-axis and the Y-axis about the Z-axis. This rotation causes a Coriolis force in direction 5001B along the Y-axis and produces a strain having an amount corresponding to the angular velocity of the rotation. Sensor 55 senses a signal corresponding to the strain to detect the angular velocity. Arms 52 of detecting element 51 of angular velocity sensor 5001 vibrate in an XZ plane including the X-axis and the Z-axis. The strain in arms 52 is produced along the Y-axis perpendicular to the XZ plane. Two arms 52 receive strain in directions opposite to each other. In other words, when one of two arms 52 deforms in a positive direction of the Y-axis, anther of two arms 52 deforms in a negative direction of the Y-axis.

Angular velocity sensor 5001 included in a navigation system installed in a vehicle arranged on an XY plane detects an angular velocity when the vehicle rotates about the Z-axis.

Arm 52 extending along the Z-axis, a rotation axis about which the angular velocity is produced prevents angular velocity sensor 5001 from having a small size along the rotation axis.
Patent Document 1: JP2005-201652A

### SUMMARY OF THE INVENTION

An angular velocity sensor detects an angular velocity of an object. The angular velocity sensor includes a detecting element, and a driving unit. The detecting element includes a supporting part, a first arm extending from the supporting part and being adapted to be fixed to the object, a second arm extending from the supporting part, and a first weight connected with the second arm. The second arm has substantially a U-shape and includes a first extending part extending from the supporting part, a first facing part facing the first extending part and extending in parallel with the first extending part, and a first joint part joining the first extending part to the first facing part. The first weight is connected with the facing part of the second arm. The driving unit includes first to fourth drivers. The first driver is provided at the first extending part and extends and contracts the first extending part. The second driver is positioned at the first extending part at a more outer circumference of the U-shape of the second arm than the first driver. The second driver extends and contracts the first extending part. The third driver is positioned at the first facing part, and extends and contracts the first facing part. The fourth driver is positioned at the first facing part at a more inner circumference of the U-shape of the second arm than the third driver, and extends and contracts the first facing part.

This angular velocity sensor has a small size along a rotation axis about which an angular velocity to be detected.

### BRIEF DESCRIPTION OF DRAWINGS

Fig. 1 is a perspective view of an angular velocity sensor according to an exemplary embodiment of the present invention.
Fig. 2 is a sectional view of the angular velocity sensor at line 2-2 shown in Fig. 1.
Fig. 3 is a perspective view of the angular velocity sensor according to the embodiment for illustrating an operation of the sensor.
Fig. 4 is a perspective view of another angular velocity sensor according to the embodiment.

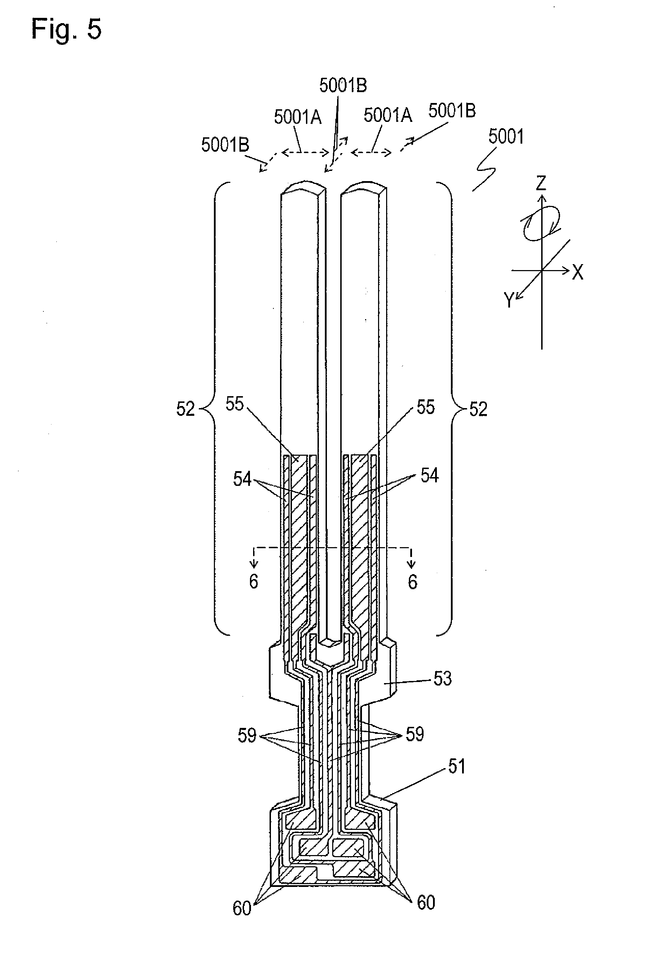

Fig. 5 is a perspective view of a conventional angular velocity sensor.
Fig. 6 is a sectional view of the angular velocity sensor at line 6-6 shown in Fig. 5.

### REFERENCE NUMERALS

- 1: Detecting Element
- 13: Piezoelectric Body
- 14: Lower Electrode
- 15: Upper Electrode
- 17: Driving unit
- 19: Sensing Unit
- 39: Sensing Unit
- 66: Supporting Part
- 102: First Arm
- 104: Second Arm
- 104C: First Extending Part
- 104D: First Joint part
- 104E: First Facing Part
- 111: First Weight
- 117A: First Driver
- 117B: Second Driver
- 119A: First Sensor
- 119B: Second Sensor
- 121A: First Wiring
- 121B: Second Wiring
- 217A: Fourth Driver
- 217B: Third Driver
- 219A: Fourth Sensor
- 219B: Third Sensor
- 204: Third Arm
- 204C: Second Extending Part
- 204D: Second Joint part
- 204E: Second Facing Part
- 211: Second Weight
- 321A: Third Wiring
- 321B: Fourth Wiring
- 1001: Angular Velocity Sensor
- 1002: Angular Velocity Sensor
- 1500: Object

### DETAILED DESCRIPTION OF PREFERRED EMBODIMENT

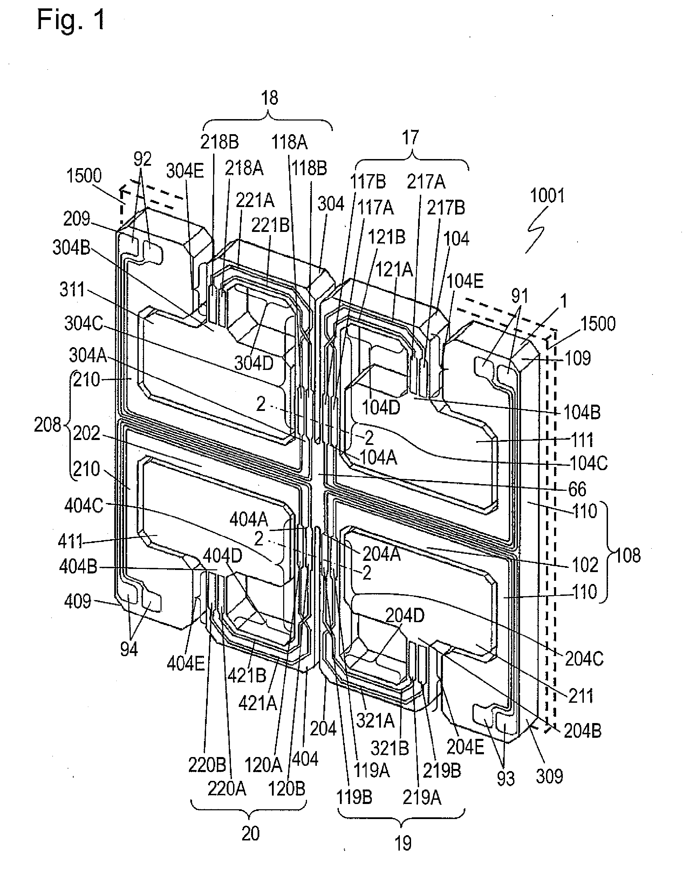

Fig. 1 is a perspective view of angular velocity sensor 1001 according to an exemplary embodiment of the present invention. Angular velocity sensor 1001 is adapted to be fixed to object 1500 so as to detect the angular velocity of a rotation of object 1500. Angular velocity sensor 1001 includes detecting element 1 which is made of a silicon plate and which is adapted to be fixed to object 1500, and further includes driving unit 17 provided on detecting element 1, detecting unit 18, first sensing unit 19, and second sensing unit 20.

Detecting element 1 includes first arm 102 extending from supporting part 66, second arm 104 extending perpendicularly to first arm 102 from supporting part 66, third arm 204 extending perpendicularly to first arm 102 from supporting part 66, fourth arm 304 extending perpendicularly to first arm 102 from supporting part 66, fifth arm 404 extending perpendicularly to first arm 102 from supporting part 66, and sixth arm 202 extending from supporting part 66 in a direction opposite to a direction in which first arm 102 extends. Second arm 104 to fifth arm 404 have substantively U-shapes. First weight 111 to fourth weight 411 are connected with second arm 104 to fifth arm 404, respectively. Seventh arm 110 is connected with an end of first arm 102. Both ends of seventh arm 110 are provided with first fixed part 109 and third fixed part 309, respectively. Fixed parts 109 and 309 are adapted to be fixed to object 1500. First arm 102, seventh arm 110, first fixed part 109, and third fixed part 309 provide first fixing arm 108 for fixing detecting element 1 to object 1500. Eighth arm 210 is connected with an end of sixth arm 202. Both ends of eighth arm 210 are provided with second fixed part 209 and fourth fixed part 409, respectively. Fixed parts 209 and 409 are adapted to be fixed to object 1500. Sixth arm 202, eighth arm 210, second fixed part 209, and fourth fixed part 409 provide second fixing arm 208 for fixing detecting element 1 to object 1500. That is, first arm 102 and sixth arm 202 are adapted to be fixed to object 1500.

Second arm 104 has first end 104A connected with supporting part 66 and second end 104B connected with first weight 111. Second arm 104 has substantially a U-shape and includes first extending part 104C extending from supporting part 66, i.e., first end 104A, first facing part 104E extending in parallel with first extending part 104C and facing first extending part 104C, and first joint part 104D joining first extending part 104C to first facing part 104E. First facing part 104E has second end 104B connected with first weight 111 of second arm 104. First facing part 104E faces first fixed part 109.

Fourth arm 304 has first end 304A connected with supporting part 66 and second end 304B connected with third weight 311. Fourth arm 304 has substantially a U-shape and includes third extending part 304C extending from supporting part 66, i.e., first end 304A, third facing part 304E extending in parallel with third extending part 304C and facing third extending part 304C, and third joint part 304D joining third extending part 304C to third facing part 304E. Third facing part 304E has second end 304B connected with third weight 311 of fourth arm 304. Third facing part 304E faces second fixed part 209.

First extending part 104C of second arm 104 and third extending part 304C of fourth arm 304 extend from supporting part 66 adjacently to each other in parallel with each other. First joint part 104D of second arm 104 and third joint part 304D of fourth arm 304 extend from first extending part 104C and third extending part 304C, respectively, in directions opposite to each other.

Third arm 204 has first end 204A connected with supporting part 66 and second end 204B connected with second weight 211. Third arm 204 has substantially a U-shape and includes second extending part 204C extending from supporting part 66, i.e., first end 204A, second facing part 204E extending in parallel with second extending part 204C and facing second extending part 204C, and second joint part 204D joining second extending part 204C to second facing part 204E. Second facing part 204E includes second end 204B connected with second weight 211 of third arm 204. Second facing part 204E faces second fixed part 309.

Fifth arm 404 has first end 404A connected with supporting part 66 and second end 404B connected with fourth weight 411. Fifth arm 404 has substantially a U-shape and includes fourth extending part 404C extending from supporting part 66, i.e., first end 404A, fourth facing part 404E extending in parallel with fourth extending part 404C and facing fourth extending part 404C, and fourth joint part 404D joining fourth extending part 404C to fourth facing part 404E. Fourth facing part 404E has second end 404B connected with fourth weight 411 of fifth arm 404. Fourth facing part 404E faces fourth fixed part 409.

Second extending part 204C of third arm 204 and fourth extending part 404C of fifth arm 404 extend from supporting part 66 adjacently to each other in parallel with each other. Second joint part 204D of third arm 204 and fourth joint part 404D of fifth arm 404 extend from second extending part 204C of third arm 204 and fourth extending part 404C of fifth arm 404, respectively, in directions opposite to each other.

Driving unit 17 is provided at second arm 104 including first extending part 104C. Detecting unit 18 is provided at fourth arm 304 including third extending part 304C facing first extending part 104C and extending in parallel with first extending part 104C. First sensing unit 19 for sensing a strain produced in third arm 204 is provided at third arm 204 including second extending part 204C. Second sensing unit 20 for sensing strain of fifth arm 404 is provided at fifth arm 404 including fourth extending part 404C facing second extending part 204C and extending in parallel with second extending part 204C.

Driving unit 17 vibrates first weight 111 connected with second end 104B of second arm 104. Driving unit 17 includes first driver 117A, second driver 117B, third driver 217B, and fourth driver 217A. First driver 117A and second driver 117B are provided on first extending part 104C of second arm 104. First driver 117A is positioned at an inner circumference of the U-shape second arm 104. Second driver 117B is positioned at a more outer circumference of the U-shape than first driver 117A is. Third driver 217B and fourth driver 217A are provided on first facing part 104E of second arm 104. Third driver 217B is positioned at an outer circumference of the U-shape of second arm 104. Fourth driver 217A is positioned at a more inner circumference of the U-shape than third driver 217B is. First driver 117A is electrically connected with third driver 217B via first wiring 121A. Second driver 117B is electrically connected with fourth driver 217A via second wiring 121B. First wiring 121A and second wiring 121B are arranged on second arm 104 and cross each other. First driver 117A and second driver 117B face each other. Third driver 217B and fourth driver 217A face each other.

Detecting unit 18 detects a vibration of fourth arm 304, namely, a vibration of third weight 311 connected with second end 304B of fourth arm 304. Detecting unit 18 includes first detector 118A, second detector 118B, third detector 218B, and fourth detector 218A. First detector 118A and second detector 118B are provided on third extending part 304C of fourth arm 304. First detector 118A is positioned at an inner circumference of the U-shape of fourth arm 304. Second detector 118B is positioned at a more outer circumference of the U-shape than first detector 118A is. Third detector 218B and fourth detector 218A are provided on third facing part 304E of fourth arm 304. Third detector 218B is positioned at an outer circumference of the U-shape of fourth arm 304. Fourth detector 218A is positioned at a more inner circumference of the U-shape than third detector 218B is. First detector 118A is electrically connected with third detector 218B via fifth wiring 221A. Second detector 118B is electrically connected with fourth detector 218A via sixth wiring 221B. Fifth wiring 221A and sixth wiring 221B are arranged on fourth arm 304 and cross each other. First detector 118A and second detector 118B face each other. Third detector 218B and fourth detector 218A face each other.

First sensing unit 19 senses a strain produced in third arm 204 due to a Coriolis force generated in second weight 211 connected with second end 204B of third arm 204. First sensing unit 19 includes first sensor 119A, second sensor 119B, third sensor 219B, and fourth sensor 219A. First sensor 119A and second sensor 119B are provided on second extending part 204C of third arm 204. First sensor 119A is positioned at an inner circumference of the U-shape of third arm 204. Second sensor 119B is positioned at a more outer circumference of the U-shape than first sensor 119A is. Third sensor 219B and fourth sensor 219A are provided on second facing part 204E of third arm 204. Third sensor 219B is positioned at an outer circumference of the U-shape of third arm 204. Fourth sensor 219A is positioned at a more inner circumference of the U-shape than third sensor 219B is. First sensor 119A is electrically connected with third sensor 219B via third wiring 321A. Second sensor 119B is electrically connected with fourth sensor 219A via fourth wiring 321B. Third wiring 321A and fourth wiring 321B are arranged on third arm 204 and cross each other. First sensor 119A and second sensor 119B face each other. Third sensor 219B and fourth sensor 219A face each other.

Second sensing unit 20 senses a strain produced in fifth arm 404 due to a Coriolis force generated in fourth weight 411 connected with second end 404B of fifth arm 404. Second sensing unit 20 includes fifth sensor 120A, sixth sensor 120B, seventh sensor 220B, and eighth sensor 220A. Fifth sensor 120A and sixth sensor 120B are provided on fourth extending part 404C of fifth arm 404. Fifth sensor 120A is positioned at an inner circumference of the U-shape of fifth arm 404. Sixth sensor 120B is positioned at a more outer circumference of the U-shape than fifth sensor 120A is. Seventh sensor 220B and eighth sensor 220A are provided on fourth facing part 404E of fifth arm 404. Seventh sensor 220B is positioned at an outer circumference of the U-shape of fifth arm 404. Eighth sensor 220A is positioned at a more inner circumference of the U-shape than seventh sensor 220B is. Fifth sensor 120A is electrically connected with seventh sensor 220B via seventh wiring 421A. Sixth sensor 120B is electrically connected with eighth sensor 220A via eighth wiring 421B. Seventh wiring 421A and eighth wiring 421B are arranged on fifth arm 404 and cross each other. Fifth sensor 120A and sixth sensor 120B face each other. Seventh sensor 220B and eighth sensor 220A face each other.

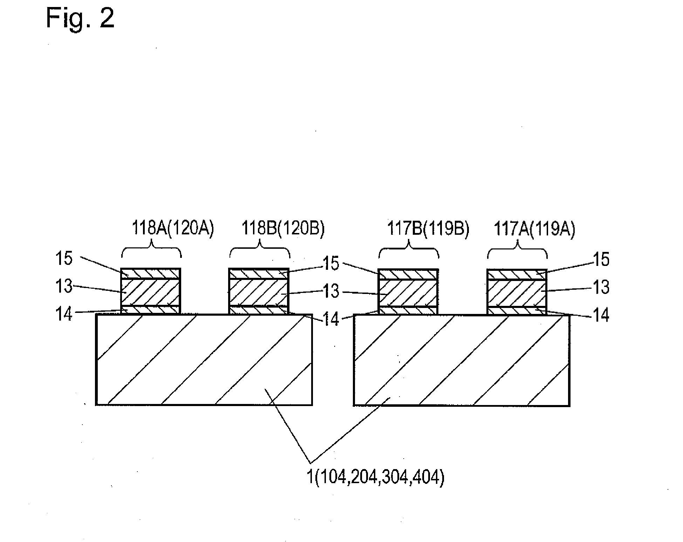

Fig. 2 is a sectional view of angular velocity sensor 1001 ay line 2-2 shown in Fig. 1. Each of drivers 117A, 117B, 217A, and 217B detectors 118A, 118B, 218A, and 218B, and sensors 119A, 119B, 219A, 219B, 120A, 120B, 220A, and 220B includes lower electrode 14 provided on detecting element 1 (i.e. arms 104 to 404), piezoelectric body 13 provided on lower electrode 14, and upper electrode 15 provided on piezoelectric body 13. Lower electrode 14 is formed by depositing Pt onto a silicon plate, i.e., detecting element 1, by high-frequency sputtering. Piezoelectric body 13 is formed by depositing lead titanate zirconate (PZT) onto lower electrode 14 by high-frequency sputtering. Upper electrode 15 is formed by vapor-depositing Au onto piezoelectric body 13. Upper electrode 15 and lower electrode 14 are connected with terminals 91 to 94 each provided on fixed parts 109, 209, 309, and 409. In other words, upper electrode 15 and lower electrode 14 of drivers 117A, 117B, 217A, and 217B are connected with terminals 91 provided on first fixed part 109. Upper electrode 15 and lower electrode 14 of detectors 118A, 118B, 218A, and 218B are connected with terminals 92 provided on second fixed part 209. Upper electrode 15 and lower electrode 14 of first sensors 119A, 119B, 219A, and 219B are connected with terminals 93 provided on third fixed part 309. Upper electrode 15 and lower electrode 14 of sensors 120A, 120B, 220A, and 220B are connected with terminals 94 provided on fourth fixed part 409.

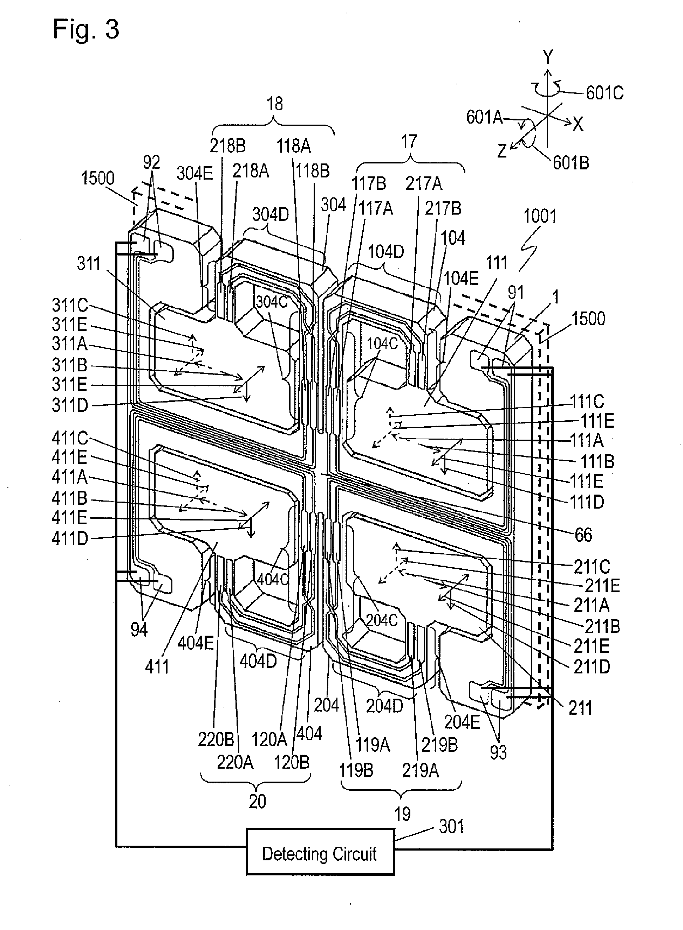

An operation of angular velocity sensor 1001 will be described below. Fig. 3 is a perspective view of angular velocity sensor 1001 for illustrating the operation of sensor 1001. Terminals 91 to 94 are connected with detecting circuit 301. Fixed parts 109, 209, 309, and 409 are fixed to object 1500 which rotates. Supporting part 66 is not fixed to object 1500.

The direction of angular velocity sensor 1001 is defined in an XYZ-coordinate space defined by an X-axis, a Y-axis, and a Z-axis, perpendicular to each other. First arm 102, supporting part 66, and sixth arm 202 are arranged substantially along a straight line. In the case that supporting part 66 is positioned at the origin of the XYZ-coordinate space and that first arm 102 and sixth arm 202 extend in positive and negative directions of the X-axis, respectively, angular velocity sensor 1001 is arranged so that second arm 104 and fourth arm 304 extend in a positive direction of the Y-axis, and that third arm 204 and fifth arm 404 extend in a negative direction of the Y-axis.

Second arm 104 connected with first weight 111, fourth arm 304 connected with third weight 311, third arm 204 connected with second weight 211, and fifth arm 404 connected with fourth weight 411 have the same resonance frequency and vibrate in an XY-plane at the resonance frequency.

Detecting circuit 301 applies an alternating current (AC) voltage having the resonance frequency via terminal 91 to upper electrode 15 and lower electrode 14 of each of first driver 117A, second driver 117B, third driver 217B, and fourth driver 217A of driving unit 17. Then, drivers 117A, 117B, 217A, and 217B partially extend and contract first extending part 104C and first facing part 104E to vibrate second arm 104 and first weight 111. Supporting part 66 is not fixed to object 1500, hence being capable of vibrating. Upon first weight 111 vibrating, supporting part 66 vibrates, and then, the vibration propagates to arms 204, 304, and 404 via supporting part 66, thereby vibrating weights 211, 311, and 411 at the resonance frequency. At this moment, if object 1500 rotates, a Coriolis force according to the angular velocity of the rotation is generated in second weight 211 and fourth weight 411 to produce strain in third arm 204 and fifth arm 404. First sensing unit 19 (i.e. first sensor 119A, second sensor 119B, third sensor 219B, and fourth sensor 219A) and second sensing unit 20 (i.e. fifth sensor 120A, sixth sensor 120B, seventh sensor 220B, and eighth sensor 220A) output voltages corresponding to the strain generated in third arm 204 and fifth arm 404, respectively. Detecting circuit 301 detects the angular velocity of object 1500 based on these voltages.

The vibration of detecting element 1 will be described in detail below. Detecting circuit 301 applies the AC voltage having the resonance frequency between upper electrode 15 and lower electrode 14 of each of first driver 117A and third driver 217B connected with each other via first wiring 121A. Then, first driver 117A and third driver 217B simultaneously extend the inner circumference of first extending part 104C and the outer circumference of first facing part 104E, respectively, and simultaneously contract the inner circumference of first extending part 104C and the outer circumference of first facing part 104E, respectively. Detecting circuit 301 applies the AC voltage which has the resonance frequency and which has a phase opposite to that of the AC voltage applied to first driver 117A and third driver 217Bz between upper electrode 15 and lower electrode 14 of each second driver 117B and fourth driver 217A connected with each other via wiring 121B. While first driver 117A and third driver 217B simultaneously contract the inner circumference of first extending part 104C and the outer circumference of first facing part 104E, respectively, second driver 117B and fourth driver 217A simultaneously extend the outer circumference of first extending part 104 and the inner circumference of first facing part 104E, respectively. Further, while first driver 117A and third driver 217B simultaneously extend the inner circumference of first extending part 104C and the outer circumference of first facing part 104E, respectively, second driver 117B and fourth driver 217A simultaneously contract the outer circumference of first extending part 104C and the inner circumference of first facing part 104E, respectively. This operation allows first weight 111 to vibrate at a large amplitude in directions 111A and 111B in parallel with the X-axis. This vibration propagates to third weight 311, second weight 211, and fourth weight 411 via supporting part 66. The propagating vibration vibrates third weight 311 in directions 311A and 311B both parallel with the X-axis, vibrates second weight 211 in directions 211A and 211B both parallel with the X-axis, and vibrates fourth weight 411 in directions 411A and 411B both parallel with the X-axis.

When third weight 311 vibrates in directions 311A and 311B, first detector 118A, second detector 118B, third detector 218B, and fourth detector 218A of detecting unit 18 provided on fourth arm 304 outputs, to terminals 92, voltages according to the vibration. Detecting circuit 301 controls, based on the voltages, the voltage applied to terminals 91, namely, the voltage for vibrating second arm 104 and first weight 111, thereby allowing first weight 111 to vibrating at a constant amplitude.

When angular velocity sensor 1001 rotates about the Z-axis in direction 601A in which second arm 104 approaches fourth arm 304 while second weight 211 vibrates and moves in directions 211A and 211B, a Coriolis force corresponding to the angular velocity of the rotation is generated in second weight 211 in directions 211C and 211D both parallel with the Y-axis. This Coriolis force causes first sensor 119A and third sensor 219B of third arm 204 to sense contraction of third arm 204, and causes second sensor 119B and fourth sensor 219A to sense extension of third arm 204. Sensors 119A, 119B, 219A, and 219B output voltages corresponding to the sensed extension and the sensed contraction of third arm 204 to terminals 93.

Similarly, when angular velocity sensor 1001 rotates about the Z-axis in a direction in which second arm 104 approaches fourth arm 304 while forth weight 411 vibrates and moves in directions 411A and 411B, a Coriolis force corresponding to the angular velocity of the rotation is generated in forth weight 411 in directions 411C and 411D both parallel with the Y-axis. The Coriolis force causes fifth sensor 120A and seventh sensor 220B of fifth arm 404 to sense contraction of fifth arm 404, and causes sixth sensor 120B and eighth sensor 220A to sense extension of fifth arm 404. Sensors 120A, 120B, 220A, and 220B output voltages corresponding to the sensed extension and the sensed contraction of fifth arm 404, to terminals 94.

When angular velocity sensor 1001 rotates about the Z-axis in a direction in which forth arm 304 approaches second arm 104 while second weight 211 vibrates and moves in directions 211A and 211B, a Coriolis force corresponding to the angular velocity of the rotation is generated in second weight 211 in directions opposite to directions 211C and 211D. This Coriolis force causes first sensor 119A and third sensor 219B of third arm 204 to sense extension of third arm 204, and causes second sensor 119B and forth sensor 219A to sense contraction of third arm 204. Sensors 119A, 119B, 219A, and 219B output voltages corresponding to the sensed extension and the sensed contraction of third arm 204, to terminals 93.

Similarly, when angular velocity sensor 1001 rotates about the Z-axis in a direction in which forth arm 304 approaches second arm 104 while forth weight 411 vibrates and moves in directions 411A and 411B, a Coriolis force corresponding to the angular velocity of the rotation is generated in forth weight 411 in directions opposite to directions 411C and 411D. This Coriolis force causes fifth sensor 120A and seventh sensor 220B of fifth arm 404 to sense extension of fifth arm 404, and causes sixth sensor 120B and eighth sensor 220A to sense contraction of fifth arm 404. Sensors 120A, 120B, 220A, and 220B output voltages corresponding to the sensed extension and the sensed contraction of fifth arm 404, to terminals 94.

Detecting circuit 301 detects the angular velocity of the rotation of angular velocity sensor 1001 about the Z-axis based on the voltages output to terminals 93 and 94.

When angular velocity sensor 1001 rotates about the Y-axis in direction 601C, a Coriolis force is generated in weights 111, 211, 311, and 411 in directions 111E, 111F, 211E, 211E, 211F, 311E, 311F, 411E, and 411F perpendicular to directions 111A, 111B, 211A, 211B, 311A, 311B, 411A, 411B and to the Y-axis. This Cotiolis force displaces second weight 211 and fourth weight 411, and causes third arm 204 and fifth arm 404 to partially extend and contract. Sensors 119A, 119B, 120A, 120B, 219A, 219B, 220A, and 220B output voltages corresponding to this extension and contraction, to terminals 93 and 94. Detecting circuit 301 detects the angular velocity of the rotation of angular velocity sensor 1001 about the Y-axis based on the voltages output to terminals 93 and 94.

In angular velocity sensor 1001, all of arms 102, 104, 204, 304, 404, and 202 extend in a direction perpendicular to the Z-axis, the rotation axis of the angular velocity to be detected, not in the direction parallel with the Z-axis. Hence, angular velocity sensor 1001 has a small size in the direction of the rotation axis.

Driving unit 17 provided on second arm 104 having the U-shape performs the extending and the contracting of the inner circumference of first extending part 104C simultaneously to the extending and the contracting of the outer circumference of first facing part 104E. Further, driving unit 17 simultaneously extends the outer circumference of first extending part 104C and the inner circumference of first facing part 104E and simultaneously contracts the outer circumference of first extending part 104C and the inner circumference of first facing part 104E. In particular, driving unit 17 simultaneously contracts the outer circumference of first extending part 104C and the inner circumference of first facing part 104E while simultaneously extending the inner circumference of first extending part 104C and the outer circumference of first facing part 104E. Driving unit 17 simultaneously extends the outer circumference of first extending part 104C and the inner circumference of first facing part 104E while simultaneously contracting the inner circumference of first extending part 104C and the outer circumference of first facing part 104E. Repeating these extensions and contractions, driving unit 17 can largely vibrate first weight 111 in directions 111A and 111B perpendicular to first extending part 104C and to first facing part 104E.

The inner circumferences and outer circumferences of first extending part 104C and first facing part 104E of the U-shape of the second arm 104 extend and contract in the direction opposite to the above-described directions. That is, the inner circumference of first extending part 104C and the inner circumference of first facing part 104E simultaneously extend and contract, and further, the outer circumference of first extending part 104 and the outer circumference of first facing part 104E simultaneously extend and contract, thus allowing second arm 104 to vibrate so that second arm 104 is wound around first weight 111. That is, first extending part 104C and first facing part 104E move first weight 111 in directions opposite to each other, and thus first weight 111 cannot vibrate with large amplitude.

First wiring 121A, fifth wiring 122A, third wiring 221A, and seventh wiring 421A cross second wiring 121B, sixth wiring 122B, fourth wiring 221B, and eighth wiring 222B on second arm 104, fourth arm 304, third arm 204, and fifth arm 404, respectively. This arrangement reduces the area where these wirings are provided, thereby decreasing the widths of arms 104, 204, 304, and 404 to reduce the size of angular velocity sensor 1001.

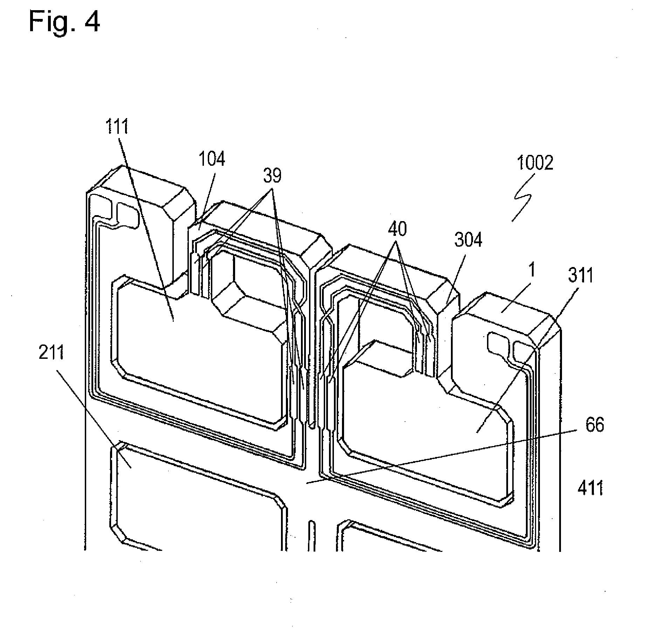

Fig. 4 is a perspective view of another angular velocity sensor 1002 according to the embodiment. In Fig. 4, components identical to those of angular velocity sensor 1001 shown in Figs. 1 to 3 are denoted by the same reference numerals, and their description will be omitted. Angular velocity sensor 1002 shown in Fig. 4 includes sensing unit 39 and sensing unit 40 provided on second arm 104 and fourth arm 304, respectively, instead of first sensing unit 19 and second sensing unit 20 of the angular velocity sensor shown in Fig. 1. Sensing units 39 and 40 have the same structures as sensing units 19 and 20. Sensing unit 39 and sensing unit 40 are provided on surfaces of second arm 104 and fourth arm 304 opposite to the surfaces of second arm 104 and fourth arm 304 having driving unit 17 and detecting unit 18 provided thereon, respectively. Strain caused by a Coriolis force generated by the angular velocity of the rotation about the Z-axis and the Y-axis is produced in second arm 104 and fourth arm 304 as well. Hence, sensing units 39 and 40 can sense the strain of second arm 104 and fourth arm 304 caused by the Coriolis force generated by the angular velocity of the rotation, similarly to sensing units 19 and 20 shown in Figs. 1 and 3, providing the same effects.

### INDUSTRIAL APPLICABILITY

An angular velocity sensor according to the present invention has a small size in a direction of a rotation axis of an angular velocity to be detected, and is applicable to various electronic devices having small sizes.

## Claims

1. An angular velocity sensor detecting an angular velocity of an object, comprising:
a detecting element including
a supporting part,
a first arm extending from the supporting part, the first arm being adapted to be fixed to the object,
a second arm extending from the supporting part, and
a first weight connected with the second arm; and
a driving unit vibrating the first weight, wherein
the second arm has substantially a U-shape and includes
a first extending part extending from the supporting part,
a first facing part facing the first extending part, the first facing part extending in parallel with the first extending part, and
a first joint part joining the first extending part to the first facing part,
the first weight is connected with the facing part of the second arm, and
the driving unit includes
a first driver provided at the first extending part, the first driver extending and contracting the first extending part,
a second driver positioned at the first extending part at a more outer circumference of the U-shape of the second arm than the first driver, the second driver extending and contracting the first extending part,
a third driver positioned at the first facing part, the third driver extending and contracting the first facing part, and
a fourth driver positioned at the first facing part at a more inner circumference of the U-shape of the second arm than the third driver, the fourth driver extending and contracting the first facing part.

2. The angular velocity sensor of claim 1, wherein
the first driver and the third driver extend and contract the first extending part and the first facing part simultaneously,
the second driver and the fourth driver extend and contract the first extending part and the first facing part simultaneously,
the second driver contracts the first extending part while the first driver extends the first extending part, and extends the first extending part while the first driver contracts the first extending part, and
the fourth driver contracts the first facing part while the third driver extends the first facing part, and extends the first facing part while the third driver contracts the first facing part.

3. The angular velocity sensor of claim 1, further comprising:
a first wiring provided on the second arm, the first wiring connecting the first driver to the third driver; and
a second wiring provided on the second arm, the second wiring connecting the second driver to the fourth driver, the second wiring crossing the first wiring

4. The angular velocity sensor of claim 1, wherein at least one of the first driver, the second driver, the third driver, and the fourth driver includes
a lower electrode provided on the second arm,
a piezoelectric body provided on the lower electrode, and
an upper electrode provided on the piezoelectric body.

5. The angular velocity sensor of claim 1, further comprising:
a third arm having substantively a U-shape and including
a second extending part extending from the supporting part in parallel with the first extending part of the second arm,
a second facing part facing the second extending part in parallel with the second extending part, and
a second joint part joining the second extending part to the second facing part;
a second weight connected with the second facing part of the third arm; and
a sensing unit including
a first sensor positioned at the second extending part, the first sensor sensing strain of the second extending part,
a second sensor positioned at the second extending part at a more outer circumference of the U-shape of the third arm than the first sensor, the second sensor sensing strain of the second extending part,
a third sensor positioned at the second facing part, the third sensor sensing strain of the second facing part, and
a fourth sensor positioned at the second facing part at a more inner circumference of the U-shape of the third arm than the third sensor, the fourth sensor sensing strain of the second facing part.

6. The angular velocity sensor of claim 5, further comprising:
a third wiring provided on the third arm, the third wiring connecting the first sensor to the third sensor; and
a fourth wiring provided on the third arm, the fourth wiring connecting the second sensor to the fourth sensor, the fourth wiring crossing the third wiring.

7. The angular velocity sensor of claim 5, wherein at least one of the first sensor, the second sensor, the third sensor, and the fourth sensor includes
a lower electrode provided on the third arm,
a piezoelectric body provided on the lower electrode, and
an upper electrode provided on the piezoelectric body.

8. The angular velocity sensor of claim 1, further comprising a sensing unit including
a first sensor positioned at the first extending part, the first sensor sensing strain of the first extending part,
a second sensor positioned at the first extending part at a more outer circumference of the U-shape of the second arm than the first sensor, the second sensor sensing strain of the first extending part,
a third sensor positioned at the first facing part, the third sensor sensing strain of the first facing part, and
a fourth sensor positioned at the first facing part at a more inner circumference of the U-shape of the second arm than the third sensor, the fourth sensor sensing strain of the first facing part.

9. An angular velocity sensor comprising a detecting element including:
two arms including a first arm and a second arm connected substantially perpendicularly to each other;
a supporting part supporting the first arm;
a fixing arm joined to the supporting part and fixed to a board; and
a weight joined to a tip of the second arm, wherein
the second arm is bent to face the second arm itself, and has a driving unit provided thereon, the driving and vibrating the weight in a direction facing the second arm, and
the driving unit includes
first drivers provided at the second arm, one of the first drivers being provided at an inner circumference of the second arm at a side approximating to the first arm, another of the first drivers being provided at an outer circumference of the second arm at a side approximating to the weight, and
second drivers provided at the second arm, one of the second drivers being provided at an outer circumference of the second arm at a side approximating to the first arm, another of the second drivers being provided at an inner circumference of the second arm at a side approximating to the weight.

10. The angular velocity sensor of claim 9, wherein
the driving unit includes
the first drivers provided at the second arm, one of the first drivers being provided at the inner circumference of the second arm at the side approximating to the first arm, another of the first drivers being provided at the outer circumference of the second arm at the side approximating to the weight, the first drivers being connected with each other via a first wiring,
the second drivers provided at the second arm, one of the second drivers being provided at the outer circumference of the second arm at the side approximating to the first arm, another of the second drivers being provided at the inner circumference of the second arm at the side approximating to the weight, the second drivers being connected with each other via a second wiring crossing the first wiring.

11. The angular velocity sensor of claim 9, wherein each of the first driver and the second driver includes an upper electrode, a lower electrode, and a piezoelectric body provided between an upper electrode and a lower electrode.

12. The angular velocity sensor of claim 9, further comprising
a sensing unit sensing strain of the second arm,
wherein the sensing unit includes
first sensors provided at the second arm, one of the first sensors being provided at an inner circumference of the second arm at a side approximating to the first arm, another of the first sensors being provided at an outer circumference of the second arm at a side approximating to the weight, and
second sensors provided at the second arm, one of the second sensors being provided at an outer circumference of the second arm at a side approximating to the first arm, another of the second sensors being provided at an inner circumference of the second arm at a side approximating to the weight.

13. The angular velocity sensor of claim 9, wherein
the sensing unit senses strain of the second arm,
the sensing unit includes
the sensors provided at the second arm, one of the first sensors being provided at the inner circumference of the second arm at the side approximating to the first arm, another of the first sensors being provided at the outer circumference of the second arm at the side approximating to the weight, the first drivers being connected with each other via a first wiring,
the second sensors provided at the second arm, one of the second sensors being provided at the outer circumference of the second arm at the side approximating to the first arm, another of the second sensors being provided at the inner circumference of the second arm at the side approximating to the weight, the second drivers being connected with each other via a second wiring crossing the first wiring.

14. The angular velocity sensor of claim 12, wherein each of the first sensor and the second sensor electrode includes an upper electrode, a lower electrode, and a piezoelectric body provided between an upper electrode and a lower electrode.
